# EUROPÄISCHE PATENTSCHRIFT

(11) **EP 1 782 468 B1**
(45) Veröffentlichungstag und Bekanntmachung des Hinweises auf die Patenterteilung: **15.02.2017**
(21) Anmeldenummer: 05779139.4
(22) Anmeldetag: 10.08.2005
(51) Int. Cl.: H01L 23/34, H01L 23/367, H01L 23/10

(54) **ELEKTRISCHE VORRICHTUNG MIT EINEM GEHÄUSE UND EINEM KÜHLKÖRPER**
ELECTRIC DEVICE COMPRISING A HOUSING AND A COOLING BODY
DISPOSITIF ELECTRIQUE COMPORTANT UN BOITIER ET UN DISSIPATEUR DE CHALEUR

(30) Priorität: 21.08.2004 DE 102004040596
(43) Veröffentlichungstag der Anmeldung: 09.05.2007
(73) Patentinhaber: ROBERT BOSCH GMBH, 70442 Stuttgart (DE)
(72) Erfinder: MILLER, Hans-Peter, 70374 Stuttgart (DE); DOEFFINGER, Andreas, 71229 Leonberg (DE); REYES TELLO, Laura, South Glamorgan South Glamorgan CF7 8 (GB); SHAW, Nigel, Sketty, Swansea West Glamorgan SA2 8LR (GB); BROWN, Tim, Henllys Cwmbran South Wales NP44 6EB (GB)
(86) Internationale Anmeldenummer: PCT/EP2005/053948
(87) Internationale Veröffentlichungsnummer: WO 2006/021512

(56) Entgegenhaltungen:
- US-A- 3 408 451
- US-A- 4 249 034
- US-A- 5 471 027
- US-A- 6 143 590
- US-B1- 6 282 096
- US-B1- 6 294 408

## Beschreibung

### Stand der Technik

Die Erfindung betrifft eine elektrische Vorrichtung mit einem Gehäuse und einem Kühlkörper und ganz besonders die mechanische Verbindung zwischen Kühlkörper und Gehäuse. Bekannte elektrische Vorrichtungen dieser Art haben einen Kühlkörper, der dadurch im Gehäuse gehalten ist, dass der Kühlkörper von das Gehäuse bildender Spritzgussmasse umspritzt ist. Dabei entsteht ein Formschluss zwischen Kühlkörper und Gehäuse, der sowohl zu einer dichten Verknüpfung, als auch zu einer sicheren mechanischen Befestigung führt. Im Rahmen der Erfindung ist vorgesehen, die Dichtwirkung zwischen Kühlkörper und Gehäuse weiter zu verbessern.

Ein Gehäuse mit einem Kühlkörper ist aus US-Patent Nr. 6294408 bekannt.

### Vorteile der Erfindung

Die erfmdungsgemäße elektrische Vorrichtung mit einem Gehäuse und einem Kühlkörper mit den Merkmalen des Hauptanspruchs hat den Vorteil, dass durch das Ausbilden einer Fuge zwischen dem Kühlkörper und dem separaten Gehäuse, die zumindest teilweise aus einem eine Öffnung umgebenden Kragen und einer den Kragen aufnehmenden Nut besteht, wobei zwischen Kragen und Nut ein Dichtmittel ist, das die Fuge zumindest flüssigkeitsdicht verschließt, eine hervorragende Dichtigkeit zwischen Gehäuse und Kühlkörper zur Folge hat.

Profiliert man den Kragen derart, dass eine Wölbung auf einer, von der Öffnung abgewandten Seite des Kragens ist, so ergibt sich in Zusammenwirkung mit der Nut und dem darin befmdlichen Dichtmittel, dass das nicht oder noch nicht erstarrte Dichtmittel durch den Kragen von der Öffnung etwas weggedrängt wird und somit nicht die Gefahr besteht, dass zuviel Dichtmittel in die Öffnung gerät. Zuviel Dichtmittel in der Öffnung könnte dazu führen, dass in die Öffnung hereinragende Teile des Kühlkörpers mit Dichtmittel benetzt werden. Der Kragen gibt somit in Zusammenwirkung mit der Nut gewissermaßen für Teile des Dichtmittels eine definierte Strömungsrichtung vor.

Umgibt die Nut ein Podest, welches in die Öffnung hineinragt, so können Bauteiltoleranzen großzügiger gehandhabt werden, da durch die Ausbildung eines Podests sich ein Strömungswiderstand für das Dichmittel in der Öffnung vergrößert und auch hier dieses Podest mit seiner relativ großen Oberfläche als Strömungsregulanz wirkt (Drossel). Die Profilierung des Kragens ist in diesem Fall auch deswegen vorteilhaft, weil dadurch das Dichtmittel nicht auf eine in die Öffnung hereinragende Oberfläche des Podests geraten kann. Diese Oberfläche ist dazu vorgesehen, entweder einen Substratträger (LBS) aufzunehmen, oder direkt ein Substrat, das als Träger für elektronische Bauteile dient.

Weiter ist vorgesehen, dass die Nut im Bereich ihrer zum Gehäuse ragenden Öffnung eine Verbreiterung aufweist, die sich auf der vom Podest abgewandten Seite der Nut erstreckt. Diese Verbreiterung der Nut hat den Vorteil, dass beispielsweise überschüssiges Dichtmittel, das durch den Kragen aus dem Nutgrund in obere Bereiche der Nut verdrängt wird, dort aufgenommen wird, ohne eine Anlagefläche zwischen Kühlkörper und Gehäuse zu benetzen. Diese Verbreiterung ist somit eine Maßnahme, um die Dichtigkeit zwischen Gehäuse und Kühlkörper sicherzustellen.

Nach einer weiteren Ausgestaltung der Erfindung ist vorgesehen, dass das Podest eine Anlagefläche des Kühlkörpers am Gehäuse überragt. Dies hat den Vorteil, dass trotz der Montage des Kühlkörpers von der Außenseite des Gehäuses, sich weiterhin eine verhältnismäßig nahe am Boden des Gehäuseinnenraums befindende Montagefläche für den Substratträger oder das Substrat ergibt. Dies erleichtert die Montage des LBS mit dem Substrat oder nur des Substrats auf dem Podest.

### Zeichnungen

In den Zeichnungen sind Ausführungsbeispiele einer erfmdungsgemäßen elektrischen Vorrichtung dargestellt. Es zeigen:
Figur 1 einen Querschnitt durch das Gehäuse und seinen Innenraum sowie durch den an das Gehäuse gefügten Kühlkörper,
Figur 2 ausschnittweise eine Variante der Gestaltung der Nut im Kühlkörper.

### Beschreibung

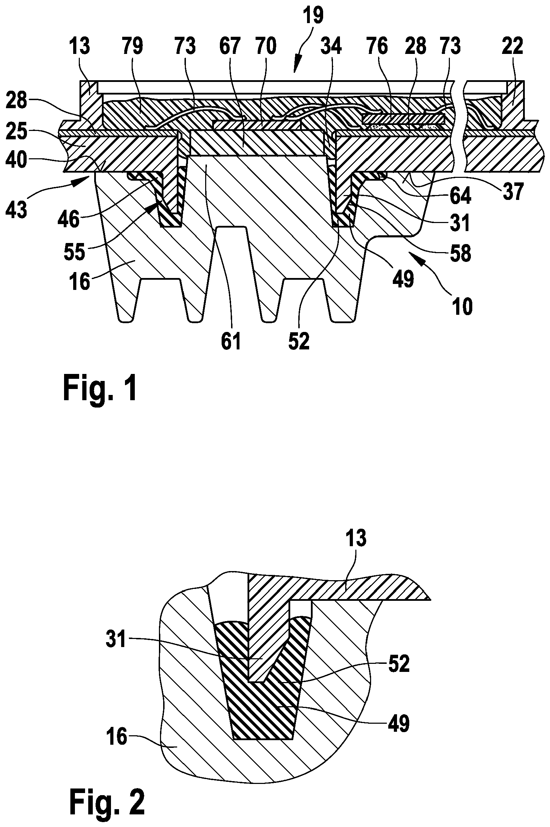

In Figur 1 ist ausschnittweise ein Querschnitt durch eine elektrische Vorrichtung 10 mit einem Gehäuse 13 und einem Kühlkörper 16 dargestellt. Das Gehäuse 13 weist einen Gehäuseinnenraum 19 auf, der von einer Wandung 22 umgeben ist. Der Gehäuseinnenraum 19 ist des Weiteren durch einen Boden 25 begrenzt. Die Oberfläche des Bodens 25 ist teilweise durch die Oberfläche von in den Gehäuse 13 angeordneten Leitern 28 gebildet. Das Gehäuse 13 weist zu einer Seite des Bodens 25 den Gehäuseinnenraum 19 auf, der durch die Wandung 22 begrenzt ist und andererseits auf der andere Seite des Bodens 25 einen Kragen 31, der eine in dem Boden 25 vorgesehene Öffnung 34 verlängert bzw. diese über den Boden 25 hinaus über den gesamten Umfang der Öffnung 34 begrenzt. Die vom Gehäuseinnenraum 19 abgewandte Oberfläche des Gehäuseteils 13 bildet eine Anlagefläche 37 für den Kühlkörper 16. An dieser Anlagefläche 37 des Gehäuses 13 liegt der Kühlkörper 16 mit seiner Anlagefläche 40 an. Zwischen dem Kühlkörper 16 und dem Gehäuse 13 ist eine Fuge 43 gebildet, die zunächst zwischen den Anlageflächen 37 und 40 gebildet ist. Diese Fuge 43 geht über in einen Zwischenraum 46, der durch eine Nut 49 im Kühlkörper 16 und den Kragen 31 gebildet ist, der in der Nut 49 angeordnet ist. In dieser Nut 49 ist ein Dichtmittel 52 eingebracht, das die Fuge 43 zwischen Kragen 31 und Nut 49 zumindest flüssigkeitsdicht verschließt.

Es ist somit eine elektrische Vorrichtung 10 mit einem Gehäuse 13 und einem Kühlkörper 16 vorgesehen, wobei der Kühlkörper 16 an dem Gehäuse 13 befestigt ist. Zwischen dem Kühlkörper 16 und dem separaten Gehäuse 13 ist eine Fuge 43, die zumindest teilweise aus einem eine Öffnung 34 umgebenden Kragen 31 und einer den Kragen 31 aufnehmenden Nut 49 besteht. Zwischen Kragen 31 und Nut 49 ist ein Dichtmittel 52, das die Fuge 43 zumindest flüssigkeitsdicht verschließt.

Der Kragen 31 ist derart profiliert, dass auf einer von der Öffnung 34 abgewandten Seite des Kragens 31 eine Wölbung 55 ist. Alternativ kann der Kragen 31 auch so gestaltet sein, dass der beispielsweise rechteckige Kragen 31 an dem zur Nut 49 gerichteten Ende pyramidenstumpfmantelförmig gestaltet ist. Mit anderen Worten, der Kragen 31 weist auf seiner von der Öffnung 34 abgewandten Außenseite eine Fase oder Schräge 58 auf.

Die Nut 49 umgibt ein Podest 61, das in die Öffnung 34 des Gehäuses 13 hineinragt. Es ist vorgesehen, dass das Podest 61 die Anlagefläche 40 des Kühlkörpers 16 überragt.

Die Nut 49 hat im Bereich ihrer Öffnung eine Verbreiterung 64, die sich auf der vom Podest 61 abgewandten Seite der Nut erstreckt. In den Fällen, in denen das Dichtmittel 52 fertigungsbedingt gelegentlich eher großzügig bemessen ist, nimmt diese Verbreiterung 64, wie in Figur 1 dargestellt, das Dichtmittel 52 auf.

In Figur 2 ist eine einfachere Variante der Nut 49 dargestellt. Die Nut 49 hat hier keine Verbreiterung 64, so dass sich das Dichtmittel 52 ausschließlich in einer verhältnismäßig schlanken Nut 49 befmdet.

Des Weiteren ist vorgesehen, dass auf dem Podest 61 ein LBS 67 montiert ist, der ein erstes Substrat 70 trägt. Dieses Substrat 70, beispielsweise eine Reglerelektronik, ist über Bonddrähte 73 beispielsweise mit den Leitern 28 elektrisch leitfähig verbunden. Des Weiteren kann vorgesehen sein, dass in dem Gehäuseinnenraum 19 ein zweites Substrat 76 angeordnet ist, dass über Bonddrähte 73 sowohl mit Leitern 28, als auch mit dem ersten Substrat 70 verbunden ist. Es ist vorgesehen, dass die beiden Substrate 70 und 76 sowie die Bonddrähte 73 durch eine Vergussmasse 79 abgedeckt sind.

## Patentansprüche

1. Elektrische Vorrichtung (10) mit einem Gehäuse (13) und einen Kühlkörper (16), wobei der Kühlkörper (16) an dem Gehäuse (13) befestigt ist, und zwischen dem Kühlkörper (16) und dem separaten Gehäuse (13) eine Fuge (43) ist, die zumindest teilweise aus einem eine Öffnung (34) umgebenden Kragen (31) und einer, den Kragen (31) aufnehmenden Nut (49) besteht, wobei zwischen Kragen (31) und Nut (49) ein Dichtmittel (52) ist, das die Fuge (43) zumindest flüssigkeitsdicht verschließt, wobei die Nut (49) ein Podest (61) umgibt, das in die Öffnung (34) hereinragt, und die Nut (49) im Bereich ihrer Öffnung eine Verbreiterung (64) aufweist, die sich auf der vom Podest (61) abgewandten Seite erstreckt.

2. Elektrische Vorrichtung nach Anspruch 1, **dadurch gekennzeichnet, dass** der Kragen (31) derart profiliert ist, dass eine Wölbung (55) auf einer von der Öffnung (34) abgewandten Seite des Kragens (31) ist.

3. Elektrische Vorrichtung nach Anspruch 1, **dadurch gekennzeichnet, dass** die Verbreiterung (64) Dichtmittel (52) aufnimmt.

4. Elektrische Vorrichtung nach Anspruch 1 oder 3, **dadurch gekennzeichnet, dass** das Podest 61 eine Anlagefläche (40) des Kühlkörpers (16) überragt.

## Claims

1. Electrical apparatus (10) comprising a housing (13) and a heat sink (16), wherein the heat sink (16) is fastened to the housing (13) and there is a join (43), which at least partially consists of a collar (31) which surrounds an opening (34) and a groove (49) which accommodates the collar (31), between the heat sink (16) and the separate housing (13), wherein there is a sealing means (52), which closes the join (43) at least in a liquid-tight manner, between the collar (31) and the groove (49), wherein the groove (49) surrounds a pedestal (61) which protrudes into the opening (34), and the groove (49) has a widened portion (64) in the region of its opening, the said widened portion extending on the side which is averted from the pedestal (61).

2. Electrical apparatus according to Claim 1, **characterized in that** the collar (31) is profiled in such a way that there is a curvature (55) on a side of the collar (31) which is averted from the opening (34).

3. Electrical apparatus according to Claim 1, **characterized in that** the widened portion (64) accommodates sealing means (52).

4. Electrical apparatus according to Claim 1 or 3, **characterized in that** the pedestal (61) protrudes beyond a contact surface (40) of the heat sink (16).

## Revendications

1. Dispositif électrique (10), avec un boîtier (13) et un dissipateur thermique (16), le dissipateur thermique (16) étant fixé sur le boîtier (13) et entre le dissipateur thermique (16) et le boîtier (13) séparé se trouvant une jonction (43) qui est constituée au moins en partie d'une collerette (31) entourant un orifice (34) et une rainure (49) recevant la collerette (31),
entre la collerette (31) et la rainure (49) se trouvant un moyen d'étanchéité (52) qui ferme la jonction (43) de manière au moins étanche aux liquides,
la rainure (49) entourant un socle (61) qui saillit à l'intérieur de l'orifice (34) et
dans la région de son orifice, la rainure (49) comportant un élargissement (64) qui s'étend sur le côté opposé au socle (61).

2. Dispositif électrique selon la revendication 1, **caractérisé en ce que** la collerette (31) est profilée de telle sorte qu'une voûte (55) se trouve sur un côté de la collerette (31) qui est opposé à l'orifice (34).

3. Dispositif électrique selon la revendication 1, **caractérisé en ce que** l'élargissement (64) réceptionne des moyens d'étanchéité (52).

4. Dispositif électrique selon la revendication 1 ou la revendication 3, **caractérisé en ce que** le socle (61) saillit par-dessus une surface d'appui (40) du dissipateur thermique (16).
